# EUROPÄISCHE PATENTSCHRIFT

(11) **EP 2 274 510 B1**
(45) Veröffentlichungstag und Bekanntmachung des Hinweises auf die Patenterteilung: **07.03.2012**
(21) Anmeldenummer: 09741950.1
(22) Anmeldetag: 30.03.2009
(51) Int. Cl.: F02D 41/22, H01L 41/04

(54) **VERFAHREN UND VORRICHTUNG ZUR ÜBERWACHUNG EINES PIEZOAKTORS**
METHOD AND DEVICE FOR MONITORING A PIEZOELECTRIC ACTUATOR
PROCÉDÉ ET DISPOSITIF DE SURVEILLANCE D'UN ACTIONNEUR PIÉZOÉLECTRIQUE

(30) Priorität: 06.05.2008 DE 102008001571
(43) Veröffentlichungstag der Anmeldung: 19.01.2011
(73) Patentinhaber: Robert Bosch GmbH, 70442 Stuttgart (DE)
(72) Erfinder: ZU, Yanqi, 71665 Vaihingen (Enz) (DE); SCHEMPP, Stefan, 73249 Wernau (DE); DANIC, Michael, 70469 Stuttgart-Feuerbach (DE); BITZER, Matthias, 71116 Gaertringen (DE)
(86) Internationale Anmeldenummer: PCT/EP2009/053728
(87) Internationale Veröffentlichungsnummer: WO 2009/135732

(56) Entgegenhaltungen:
- DE-A1- 10 256 331
- DE-A1- 19 910 388
- DE-B3-102004 054 372
- US-A1- 2007 227 506
- US-B1- 6 384 512

## Beschreibung

### Stand der Technik

Die Erfindung geht aus von einer Vorrichtung oder einem Verfahren nach Gattung der unabhängigen Ansprüche.

Aus der DE 197 33 560 ist ein Verfahren zum Laden und Entladen eines piezoelektrischen Elements bekannt. Der das piezoelektrische Element ladende Ladestrom bzw. der das piezoelektrische Element entladende Entladestrom wird über ein induktive Eigenschaften aufweisendes Bauelement geführt. Dabei wird ein nicht ordnungsgemäßes piezoelektrisches Element erkannt, wenn der ermittelte zeitliche Verlauf und/oder der Fortschritt des Ladens und/oder Entladens von einem bestimmungsgemäßen Verlauf und/oder Fortschritt abweicht.

Aus der US 6384512 ist ein Verfahren zur Überwachung eines Piezoaktors bekannt.

Der Ladeschalter und der zugehörige Entladeschalter sind wichtige Bauteile einer entsprechenden Vorrichtung zur Ansteuerung eines piezoelektrischen Elements. Bei jeder Ansteuerung werden die beiden Schalter betätigt. Defekte eines solchen Schalters sind problematisch. Besonders problematisch ist ein Fehler, bei dem der Ladeschalter kurzgeschlossen ist bzw. in seiner eingeschalteten Position verbleibt. Besonders problematisch ist dieser Fehler, wenn gleichzeitig ein Fehler des Entladeschalters auftritt und dieser in seinem geöffneten Zustand verbleibt. In diesem Fall liegt die komplette Bufferspannung am Stecker des Steuergeräts bzw. am Piezoaktor an. Ein solcher Fehler muss in jedem Fall sicher erkannt werden. Insbesondere muss dieser Fehler auch im laufenden Betrieb ständig erkannt werden.

### Offenbarung der Erfindung

### Vorteile der Erfindung

Die erfindungsgemäße Vorrichtung und das erfindungsgemäße Verfahren mit den Merkmalen der unabhängigen Ansprüche hat den Vorteil, dass ein Fehler des Piezoaktors bzw. seiner Ansteuerschaltung sicher erkannt werden kann. Dadurch, dass drei Bedingungen überprüft werden, kann ein entsprechender Fehler sicher erkannt und entsprechende Notmaßnahmen eingeleitet werden. Des Weiteren ist durch die Überprüfung von drei Bedingungen möglich, diesen Fehler von anderen Fehlern zu unterscheiden. Besonders vorteilhaft ist, wenn überprüft wird, ob die Spannung an dem Piezoaktor einen unzulässigen Wert annimmt, dass überprüft wird, ob ein Fehlersignal vorliegt, und dass überprüft wird, dass die Entladezeit einen unzulässigen Wert annimmt.

Durch die in den abhängigen Ansprüchen aufgeführten Maßnahmen sind vorteilhafte Weiterbildungen und Verbesserungen der im unabhängigen Anspruch angegebenen Vorrichtungen möglich.

### Zeichnung

Ausführungsbeispiele der Erfindung sind in den Zeichnungen dargestellt und in der nachfolgenden Beschreibung näher erläutert.

Es zeigen
Figur 1 ein Blockdiagramm der wesentlichen Elemente einer Schaltung zum Ansteuern eines Piezoaktors,
und Figur 2 und 3 verschiedene über Zeit aufgetragenen Signale.

### Beschreibung der Ausführungsbeispiele

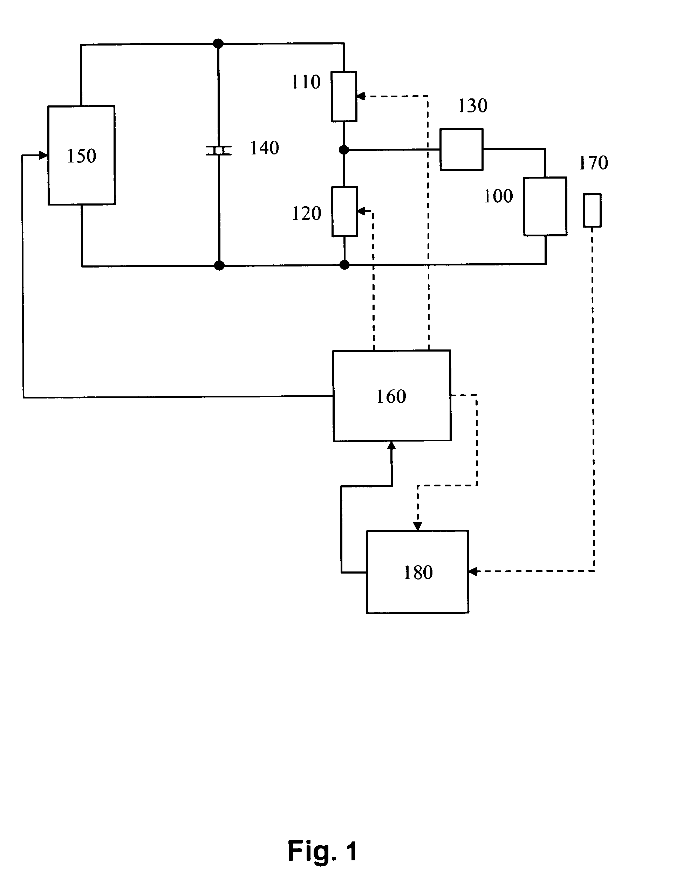

In Figur 1 sind die wesentlichen Elemente einer Schaltungsanordnung zur Ansteuerung eines Piezoaktors dargestellt. Der Piezoaktor ist mit 100 bezeichnet. Der erste Anschluss des Piezoaktors steht zum Einen mit einem Ladeschalter 110 und einem Entladeschalter 120 in Verbindung. Der gemeinsame Punkt zwischen dem Ladeschalter 110 und dem Entladeschalter 120 ist dabei vorzugsweise über eine Induktivität 130 mit dem ersten Anschluss des Piezoaktors 100 verbunden. Der von dem gemeinsamen Punkt abgewandte Anschluss des Ladeschalters 110 ist mit einem ersten Anschluss eines Bufferkondensators 140 verbunden. Der zweite Anschluss des Entladeschalters 120, der von dem gemeinsamen Punkt abgewandt ist, ist mit dem zweiten Anschluss des Bufferkondensators 140 verbunden. Die beiden Anschlüsse des Bufferkondensators 140 sind mit einem Wandler 150 verbunden. Die Ladeschalter und Entladeschalter werden von einem Endstufenbaustein 160 angesteuert. Des Weiteren ist ein Spannungserfassungsmittel 170 vorgesehen, das die am Piezoaktor 100 anliegende Spannung erfasst. Dieses beaufschlagt eine Überwachungseinheit 180 mit einem entsprechenden Signal. Ferner wertet die Überwachung 180 ein Ausgangssignal des Endstufenbausteins 160 aus.

Die in Figur 1 dargestellte Schaltung dient zur Ansteuerung eines Piezoaktors. Durch entsprechende Abwandlung der Schaltung kann diese Schaltung auch zur Ansteuerung von mehreren Piezoaktoren verwendet werden. Insbesondere ist vorgesehen, das auch für mehrere Piezoaktoren lediglich ein Lade/Entladeschalter und eine Induktivität 130 vorgesehen ist. In diesem Fall werden die anzusteuernden Piezoaktoren durch entsprechende Schaltmittel, insbesondere durch sogenannte Auswahlschalter ausgewählt.

Bei einer Ausgestaltung kann auch vorgesehen sein, dass mehrere Piezoaktoren zu einer Bank zusammengefasst werden und jeweils für mehrere Piezoaktoren die entsprechend dargestellten Bauelemente vorgesehen sind.

Diese Einrichtung arbeitet nun wie folgt. Der Wandler 150 lädt den Bufferkondensator 140 auf eine bestimmte Spannung auf. Durch Ansteuerung des Ladeschalters wird der Piezoaktor 100 auf eine vorgegebene Spannung aufgeladen. Erreicht die Spannung am Piezoaktor 100 die vorgegebene Spannung, so wird der Ladevorgang beendet und der Ladeschalter bleibt üblicherweise in seinem geöffneten Zustand. Soll der Piezoaktor entladen werden, so wird der Entladeschalter entsprechend angesteuert und der Piezoaktor wird ebenfalls über die Induktivität 130 und den Entladeschalter 120 entladen. Hierzu werden die Lade- und Entladeschalter sowie die weiteren nicht dargestellten Schalter, wie Auswahlschalter, von dem Endstufenbaustein 160 angesteuert.

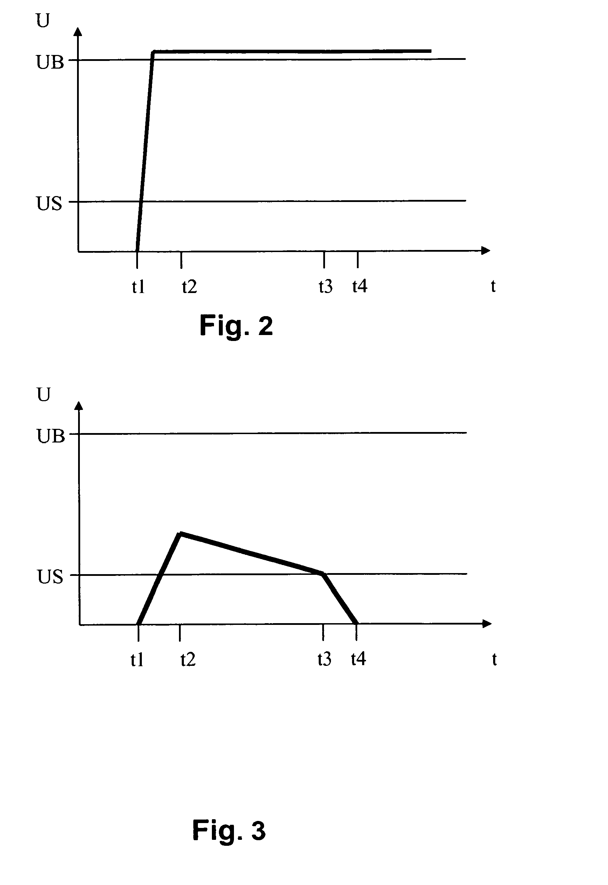

Der Spannungsverlauf eines fehlerfreien Betriebs ist in Figur 3 beispielhaft dargestellt. Zum Zeitpunkt T1 beginnt der Ladevorgang des Piezoaktors. Zum Zeitpunkt T2 erreicht die Spannung am Piezoaktor einen vorgegebenen Wert. Zu diesem Zeitpunkt endet der Ladevorgang. Üblicherweise wird die Zeitdauer zwischen dem Zeitpunkt T1 und dem Zeitpunkt T2 als Ladezeit bezeichnet. Bis zum Zeitpunkt T3 fällt die Spannung am Piezoaktor auf den Wert US ab. Zum Zeitpunkt T3 endet die Ansteuerung des Piezoaktors und durch Betätigen des Entladeschalters 120 fällt die Spannung bis zum Zeitpunkt T4 auf Null ab. Die Zeitdauer zwischen dem Zeitpunkt T3 und T4 wird üblicherweise als Entladezeit bezeichnet.

Tritt nun ein Kurzschluss im Ladeschalter auf, steigt die Spannung während des Ladevorganges wesentlich schneller und auf einen höheren Wert an. Insbesondere steigt die Spannung am Piezoaktor auf den Wert der Spannung am Bufferkondensator UB an. Ist diese Spannung erreicht, so verbleibt die Spannung am Piezoaktor auf diesem Wert. Ein Entladen ab dem Zeitpunkt T3 ist insbesondere bei einem zusätzlichen Defekt des Entladeschalters, der in einer offenen Position verbleibt, nicht mehr möglich.

Dies hat zur Folge, dass eine Entladezeit nicht mehr gemessen werden kann bzw. einen sehr großen Wert annimmt. Des Weiteren ist die erfasste Spannung zum Zeitpunkt T2 wesentlich größer als der übliche Wert.

Erfindungsgemäß ist nun vorgesehen, dass im Wesentlichen drei Größen ausgewertet werden. Zum Einen wird überprüft, ob die Entladezeit, die vorzugsweise über ein vom Endstufenbaustein 160 bereitgestelltes Signal, das von der Überwachungseinheit 180 gemessen wird, und der Zeitdauer zwischen dem Beginn des Entladevorgangs und dem Ende des Entladevorgangs entspricht, bei dem die Spannung am Piezoaktor ihren Abschaltwert erreicht. Dieser Wert der Entladezeit wird üblicherweise von dem Endstufenbaustein auf einen festgelegten Wert gesetzt, der dann von dem Endstufenbaustein ausgegeben wird, wenn die Entladezeit nicht gemessen werden kann. In der Überwachungseinheit 180 wird zur Fehlerüberwachung die Entladezeit mit einem Schwellenwert verglichen. Des Weiteren wird die Spannung, die am Piezoaktor anliegt, vorzugsweise zum Zeitpunkt T2 mit einem vorgegebenen Wert verglichen. Dieser vorgegebene Wert liegt im Bereich oberhalb der üblichen Sollabschaltspannung. Ist dieser Wert wesentlich größer als dieser vorgegebene Wert, so wird eine zweite Bedingung als vorliegend erkannt.

Üblicherweise ist vorgesehen, dass der Endstufenbaustein 160 eine Diagnose der Einrichtung durchführt. Hierzu ist vorgesehen, dass verschiedene Spannungs- und Stromwerte erfasst werden und bei einer Unplausibilität ein Fehler der Anordnung erkannt wird. In diesem Fall wird ein Fehlerbit gesetzt. Als dritte Bedingung wird überprüft, ob dieses Fehlerbit gesetzt ist.

Liegen alle diese drei Bedingungen vor, so wird ein Fehler erkannt, der anzeigt, dass der Ladeschalter in seinem geschlossenen Zustand verblieben ist bzw. dass ein Kurzschluss des Ladeschalters vorliegt. Dadurch, dass drei Bedingungen überprüft werden, ist eine Verwechslung mit anderen Defekten ausgeschlossen. Ist ein solcher Fehler erkannt, so wird von der Überwachung 180 über den Entstufenbaustein der Wandler 150 derart angesteuert, dass ein weiteres Aufladen des Bufferkondensators 140 unterbleibt und vorzugsweise wird der Bufferkondensator bei Vorliegen eines solchen Fehlers entladen. Mit dieser Maßnahme wird ein sicherer Betriebszustand der Einrichtung erreicht.

Bei Ansteuereinrichtungen, bei denen zwei Wandler und zwei Bufferkondensatoren sowie zwei Endstufenbausteine vorgesehen sind, ist in diesem Fall noch ein Notfahrbetrieb dahingehend nötig, dass nur der Wandler abgeschaltet wird, der den als defekt erkannten Ladeschalter ansteuert. In diesem Fall ist ein Notfahrbetrieb mit reduzierter Anzahl der Zylinder der Brennkraftmaschine möglich.

## Patentansprüche

1. Verfahren zur Überwachung eines Piezoaktors, **dadurch gekennzeichnet, dass** überprüft wird, ob eine Entladezeit einen unzulässigen Wert annimmt, dass überprüft wird, ob die Spannung an dem Piezoaktor einen unzulässigen Wert annimmt und dass überprüft wird, ob ein Endstufenbaustein ein Fehlersignal abgibt, wobei bei Erfülltsein der drei Bedingungen ein Kurzschluss eines Ladeschalters erkannt wird.

2. Verfahren nach Anspruch 1, **dadurch gekennzeichnet, dass** überprüft wird, ob die Entladezeit größer als ein Schwellenwert ist.

3. Verfahren nach Anspruch 1, **dadurch gekennzeichnet, dass** überprüft wird, ob die Spannung zu einem bestimmten Zeitpunkt größer als ein Schwellenwert ist.

4. Verfahren nach Anspruch 1, **dadurch gekennzeichnet, dass** zu einem Zeitpunkt, bei dem der Ladevorgang des Piezoaktors im fehlerfreien Fall beendet ist, überprüft wird, ob die Spannung größer als ein Schwellenwert ist.

5. Vorrichtung zur Überwachung eines Piezoaktors, **dadurch gekennzeichnet, dass** Mittel vorgesehen sind, die überprüfen, ob eine Entladezeit einen unzulässigen Wert annimmt, ob die Spannung an dem Piezoaktor einen unzulässigen Wert annimmt und ob ein Endstufenbaustein ein Fehlersignal abgibt, und die bei Erfülltsein der drei Bedingungen ein Kurzschluss eines Ladeschalters erkennen.

## Claims

1. Method for monitoring a piezoelectric actuator, **characterized in that** a check is carried out to determine whether a discharge time assumes an impermissible value, **in that** a check is carried out to determine whether the voltage on the piezoelectric actuator assumes an impermissible value and **in that** a check is carried out to determine whether an output stage module emits a fault signal, wherein a short circuit of a charging switch is identified if the three conditions are satisfied.

2. Method according to Claim 1, **characterized in that** a check is carried out to determine whether the discharge time is greater than a threshold value.

3. Method according to Claim 1, **characterized in that** a check is carried out to determine whether the voltage at a specific time is greater than a threshold value.

4. Method according to Claim 1, **characterized in that** a check is carried out to determine whether the voltage is greater than a threshold value at a time at which the charging process of the piezoelectric actuator is ended in the fault-free state.

5. Apparatus for monitoring a piezoelectric actuator, **characterized in that** means are provided which check whether a discharge time assumes an impermissible value, whether the voltage on the piezoelectric actuator assumes an impermissible value, and whether an output stage module emits a fault signal, and which identify a short circuit of a charging switch when the three conditions are satisfied.

## Revendications

1. Procédé de surveillance d'un piézoactionneur, **caractérisé en ce que**
il vérifie si la durée de décharge prend une valeur inadmissible,
**en ce qu'**il vérifie si la tension appliquée sur le piézoactionneur prend une valeur inadmissible et
**en ce qu'**il vérifie si un module d'étage final délivre un signal d'erreur, un court-circuit d'un commutateur de charge étant détecté au cas où les trois conditions sont remplies.

2. Procédé selon la revendication 1, **caractérisé en ce qu'**il vérifie si la durée de décharge est supérieure à une valeur de seuil.

3. Procédé selon la revendication 1, **caractérisé en ce qu'**il vérifie si la tension est supérieure à une valeur de seuil à un instant défini.

4. Procédé selon la revendication 1, **caractérisé en ce qu'**à l'instant où l'opération de charge du piézoactionneur se termine sans défaut, il vérifie si la tension est supérieure à une valeur de seuil.

5. Dispositif de surveillance d'un piézoactionneur, **caractérisé en ce qu'**il présente des moyens qui vérifient si la durée de décharge prend une valeur inadmissible, si la tension appliquée sur le piézoactionneur prend une valeur inadmissible et si un module d'étage final délivre un signal d'erreur, et qui détectent un court-circuit d'un commutateur de charge au cas où les trois conditions sont remplies.
